# EUROPEAN PATENT SPECIFICATION

(11) **EP 3 549 227 B1**
(45) Date of publication and mention of the grant of the patent: **27.10.2021**
(21) Application number: 17826279.6
(22) Date of filing: 05.12.2017
(51) Int. Cl.: H02J 4/00, H02J 3/18

(54) **A SMART SOCKET AND MONITORING AND CONTROL SYSTEM USING SAID SOCKET**
INTELLIGENTE BUCHSE SOWIE ÜBERWACHUNGS- UND STEUERUNGSSYSTEM MIT DER BESAGTEN BUCHSE
PRISE INTELLIGENTE ET SYSTÈME DE SURVEILLANCE ET DE COMMANDE UTILISANT LADITE PRISE

(30) Priority: 05.12.2016 IT 201600123334
(43) Date of publication of application: 09.10.2019
(73) Proprietor: Universita' Degli Studi di Firenze, 50121 Firenze (IT)
(72) Inventor: SOMMA, Marco, 50121 Firenze (IT); GRASSO, Francesco, 50121 Firenze (IT)
(74) Representative: Savi, Massimiliano
(86) International application number: PCT/IB2017/057634
(87) International publication number: WO 2018/104849

(56) References cited:
- WO-A1-2011/091441
- CN-U- 204 992 153
- CN-U- 205 543 522
- US-A1- 2009 322 160
- US-A1- 2013 083 805
- US-A1- 2013 261 821
- US-A1- 2014 117 780
- US-A1- 2016 156 225

## Description

### FIELD OF THE INVENTION

The invention relates to the sector of Smart Grids and Smart Metering within the scope of power grids.

### STATE-OF-THE-ART

The term "Smart Grid" is understood to mean an infrastructure/network controlled smartly, so as to be able to manage the various power flows consciously and provide end users with competitive prices.

Specifically, the ERGEG (Association of 27 European regulators) has formulated the following definition of "Smart Grid": "The Smart Grid is a power supply, which efficiently integrates and manages the conduct and action of all users connected to the power supply (generators, sampling points, and generation and sampling points) with the aim of guaranteeing a financially efficient operation of the electrical system, with low losses, an elevated level of safety and continuity and quality of the supply".

A fundamental part of Smart Grids is Smart Metering, the object of which is to know consumption profiles in real time, thus giving power supply operators the right to create mechanisms provided with greater flexibility, dynamicity, offering customers, the energy consumers, a greater understanding and awareness of their consumptions. A fundamental requisite of Smart Meter is the possibility to record various users' consumption in real-time and send the remotely acquired data.

Several devices are currently known, called smart sockets in jargon, which can measure electrical magnitudes, in particular grid voltage and current absorbed by the load. Although they carry out their role perfectly, they are nonetheless very specific devices able to process the values measured locally and provide broad indications regarding various electrical parameters, such as the power absorbed by the load, which can be used by the power supply operators to offer customers differentiated contracts based on the specific consumption characteristics. Furthermore, the Smart Grid requires sampling capacities and data processing, which go way beyond simple signal samplings and the relative processing. Document CN204992153 discloses an example of multi -functional smart socket based on Wi -Fi interfacing and connection. Document US2016/156225 discloses another example of multi -functional smart socket configured to provide real-time analysis of the main and connected loads. Document CN205543522 discloses yet another example of smart socket adapted to monitor active and reactive power to and from the mains network.

It is an object of the present invention to produce an improved smart socket and relative monitoring and system, which can be used within the scope of Smart Grids for actively managing power supply consumptions.

The invention achieves the object with a smart socket according to claim 1.

The socket is not limited to reading voltage and current data, but interacts strongly with the load thanks to the dialogue with one or more remote supervision units, which can read and process such data and send commands to control and optimize the working of the mains.

In fact, the load control devices can comprise simple modules, which act on the load supply circuit, for example, using a break device for the current circulation on the load, such as a relay, an electronic switch or the like, or, combined, either a power factor correction circuit, which reduces the reactive power on the load, or combined, elements, which allow the control unit to interface with the load, so as to allow the control unit to set at least part of the relative operating parameters directly on the load.

To this end, the control unit is advantageously configured to receive control signals from the supervision unit for remotely controlling the turning on/ off and, more generally, the working of the load, optimizing consumption or other performance indexes according to the operating parameters monitored.

According to another aspect, the invention relates to a system according to claim 6.

Advantageously, the supervision unit can be configured to process parameters from the smart socket(s) to provide an output Power Quality analysis of the mains.

Further objects, characteristics and advantages of the present invention will become clearer from the following detailed description, given by way of example, which is not limiting, illustrated in the appended figures, wherein:
Fig. 1 shows a smart socket according to one embodiment of the invention.
Fig. 2 shows an example of a current sensor usable in the socket according to the invention.
Fig. 3 shows an example of a voltage generator of reference used in combination with the current sensor in the previous figure in an improvement of the invention.
Fig. 4 shows the block diagram of a voltage recording module;
Fig. 5 shows the block diagram of a monitoring and control system according to one embodiment of the invention.
Fig. 6 reports a table with the Power Quality magnitudes, which can be measured with the system according to the invention.

### DETAILED DESCRIPTION OF THE INVENTION

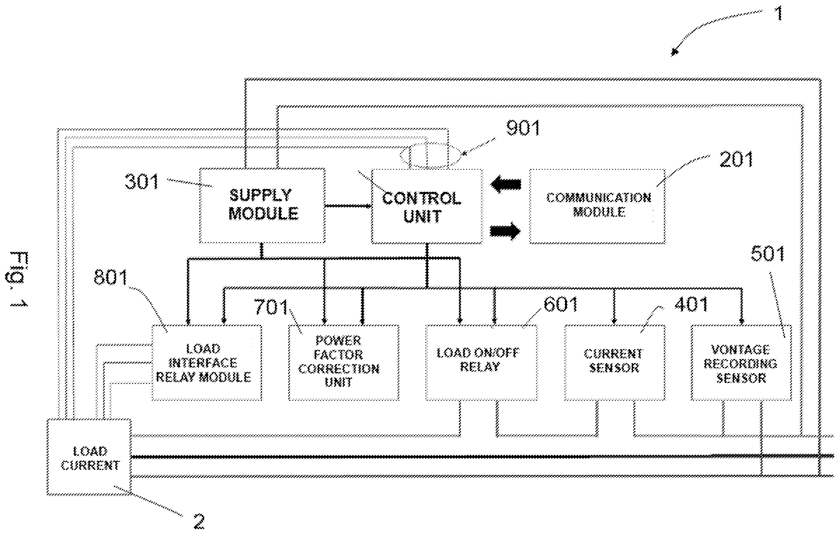

With reference to the block diagram in fig. 1, in one embodiment of the invention, the smart socket 1 comprises the following modules: a control unit 101, a communication module 201, a supply module 301, a current sensor 401, a voltage recording module 501, a load on/off relay 601, a power factor correction circuit 701, a relay module for interfacing towards the load 801 and possibly pins 901 for the direct connection between the load and the control unit.

The single components of the system will now be described.

### 1) CONTROL UNIT

The unit is based, for example, on the Arduino Due board with the following specifications:

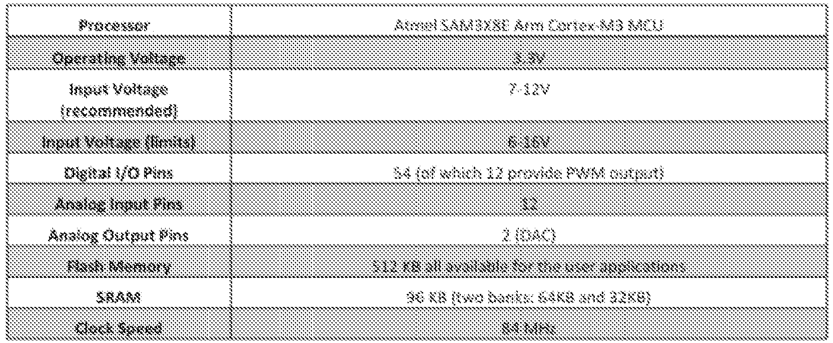

### 2) COMMUNICATION MODULE

Depending on the needs, different communication modules can be used for interfacing with the supervision unit including, for example, XBEE, Ethernet SHIELD, Bluetooth, WIFI Shield and the like.

### 3) SUPPLY MODULE

In an advantageous configuration, the supply module is produced by means of three supply sub-modules, each of which being composed of an isolation transformer, a diode bridge, capacitors and a voltage regulator, used for supplying respectively:
- the control unit;
- the load interface relay module;
- the power factor correction circuit;
- the load on/off relay.

In particular, the main components of the supply modules are:
- Isolation transformer: it allows the grid voltage to be transformed into a lower voltage. When choosing the transformer, it is necessary to consider that the tolerable input voltage (primary side voltage) must be higher than 230 VAC (standard grid voltage), this is because the device is conceived and developed with the aim of being able to record voltages higher than 230 V working (overvoltage and swell) by means of the voltage recording module, consequently the choice of classical transformers at 230 VAC would prevent such aim from being reached, resulting in the destruction of the transformer, and consequently the interruption of the supply. Similarly, the device is also conceived and developed to record voltages lower than 230 VAC (sag and undervoltage), consequently the secondary side voltage must lie within the range of admissible voltages going into the voltage regulator in these particular cases, too. Consequently, possible isolation transformer choices are:

| | **PRIMARY ADMISSIBLE VOLTAGE** | **SECONDARY ADMISSIBLE VOLTAGE** |
|---|---|---|
| **ISOLATION TRANSFORMER** | 0 / 400 VAC | 0 / 24 VAC |
| **ISOLATION TRANSFORMER** | 0 / 500 VAC | 0 / 36 VAC |

Also note that, as the isolation transformer is "only" used for transforming the grid voltage into a lower voltage and not as a measurement transformer, it can be replaced with a simple voltage divider, opportunely dimensioned, so as to generate an output voltage, which lies within the input range of the voltage regulator. Clearly, the resistances chosen must be able to withstand the voltage to which they are subjected without burning.
- Rectifier bridge: allows the voltage from the transformer and from the voltage divider to be rectified.
- Voltage regulator: allows the stabilization of the supply voltage going into the various modules. As the voltage coming out of the rectifier bridge will have an extremely wide range, it is necessary to use a voltage regulator with an equally wide interval of admissible input voltage values. For this reason, one possible choice of regulator is given by the step-down voltage regulator d24v3f5, which presents a wide range of admissible input voltage ranging from 7 to 42V.
- Capacitors: these are used to reduce the ripple and avoid possible spikes in voltage, which are potentially damaging to the regulator itself.

### 4) CURRENT SENSOR

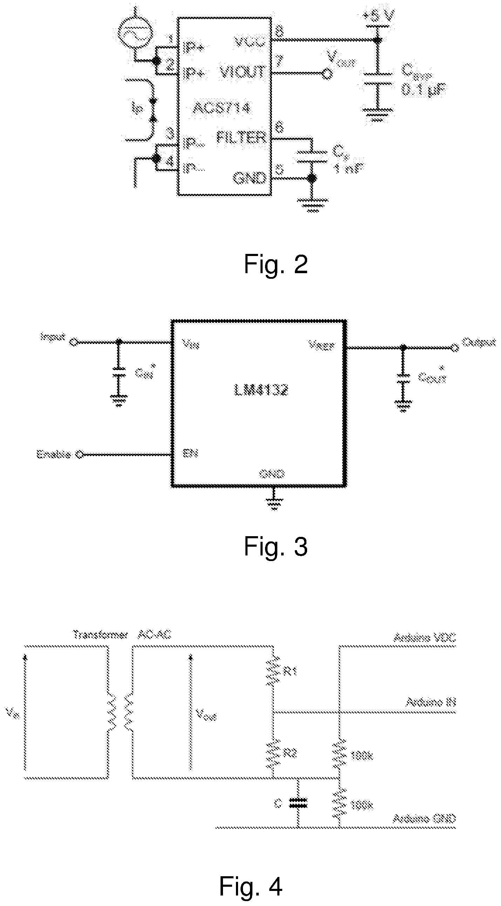

The board shown in fig. 2 comprises the sensor ACS714 developed by Allegro Microsystems. It is a linear current sensor based on the Hall effect, which has a low resistance (∼1.2m) of the electric circuit and galvanic isolation higher than 2.1 kV RMS. This version accepts a module bidirectional input current higher than 30 A and an output proportionate to the recorded current value, centered on 2.5 V if supplied at 5 V, centered at 1.65 V if supplied at 3.3 V, with a typical error of ±1.5%. The sensor works at 5V and has a sensitivity of 66 mV/A.

Such sensor was only used for financial reasons and, as can be seen from the brief description, besides not offering elevated precision, presents no internal circuit, which can compensate the offset. Also note how the sensor is conceived to work with input voltage equal to 5 VDC, however, the board used allows a maximum voltage on the analog pins equal to 3.3 V, therefore, the sensor ACS714 is supplied with such voltage. Such choice causes no significant increase in the measurement error.

In fact, an integrated LM4132 3.3V, shown in fig. 3, was used to increase the precision of the measurement, so as to reduce possible fluctuations on the VCC pin of the sensor.

The optimal solution, for control units at tolerant 3.3V, is represented by the use of Hall effect current sensors, with supply voltage equal to 3.3v or, if sensors with a higher supply voltage are desired, it is advantageous to use either bidirectional logical level transducers 3.3V - 5V (in this case for VCC = 5 VDC), or adapt the output voltage, so that it is between 0 and 3.3 V, generally more refined, so as to provide more precise measurements, which can compensate any offset.

### 5) VOLTAGE RECORDING MODULE

The module is used for acquiring the single samples of the instant voltage. With reference to fig. 4, it is composed of:
- Precision AC-AC transformer. The same transformers adopted for producing the supply modules cannot be used for the application since extremely elevated measurement precision is required, for this reason it is advantageous to use a voltage transformer with a precision class equal to 0.2. The same indications stated previously apply for the dimensioning of the transformer (primary side voltage).
- Sampling resistors, used for adapting the secondary side voltage of the transformer to the input voltage of the analog pins. Precision resistors (tolerance ≈ 1%) with a sufficiently small value (in the order of a few Ohms) are typically used to improve the precision of the measurement, this is because, as it is a voltage measurement, the impedance of the analog pin of the board must be much greater than the impedance of the resistance on which the measurement is taken.

### 6) LOAD ON/OFF RELAY

The relay is a switch with one or more electrical contacts driven by an electromagnet when the coil of the same is crossed by a current. This relay is controlled by the control unit based on the signal sent by the user via the control platform and allows the load to be activated or disabled from the mains. Naturally, electronic switches, such as SCR and the like can also be used.

### 7) POWER FACTOR CORRECTION CIRCUIT

The power factor correction circuit is made up of three relays arranged parallel connected to an equal number of correction capacitors, which are activated by the control unit. The power factor correction unit has two operating modes:
- I mode: only the first two relays work, connected to an equal number of "fixed" correction capacitors (whose value cannot be modified), which are operated according to the phase recorded, so as to reduce it and lessen the reactive power and consequently increase both the efficiency and the useful life of the electric load connected to the socket;
- II mode: only the third relay works, connected to a correction capacitor chosen by the user, which is activated according to the phase recorded.
The shift between the two operating modes is carried out by a switch.

More generally, the power factor correction circuit comprises a battery of capacitors, in parallel, which can be excluded individually by means of break devices arranged in series, such as relays, electronic switches or the like, driven by the control unit, to introduce a capacitive reactance into the supply circuit of the load, so as to compensate, at least partially, for the inductive reactance of the load, so as to take the power factor to values higher than 0.7, preferably higher than 0.8, typically higher than 0.9.

### 8) LOAD INTERFACE RELAY MODULE

The module is made up of various relays or electronic switches, which are activated by the control unit according to the signal sent from the control platform allowing the socket to be connected directly to the single commands of the electric load, for example they can be used for replacing/supporting the electromechanical buttons found in various household appliances, so as to operate a particular program depending on the needs.

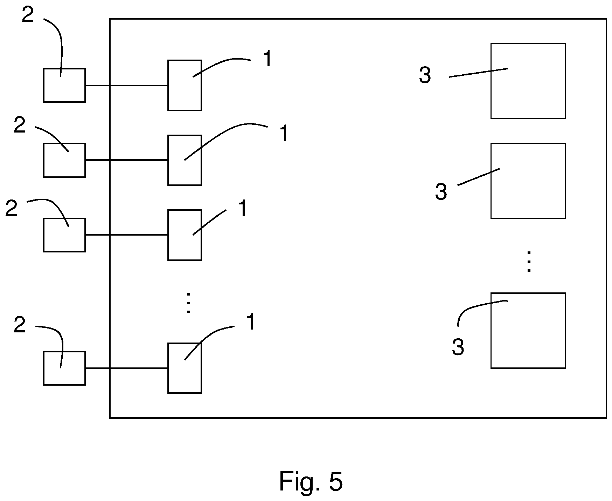

Advantageously, the socket can be included as part of a system for monitoring the operating parameters of one or more loads in a power grid. Such system, whose block diagram is shown in fig.5, comprises one or more supervision units 3 interfaced with one or more smart sockets 1 for reading data related to the mains voltage and current drawn by the load (s) 2 when such smart socket (s) are inserted in series between the electric mains and the load. Besides reading and processing the electrical data from the socket 1, advantageously, the supervision unit 3 can remotely control both the socket 1 and the load 2 connected thereto, creating a node of a Smart Grid network.

Specifically, the control unit 901 of the socket 1 can receive command signals sent by the user through the communication module 201, so as to remotely control both the turning on/off of the socket via the load on/off relay 601 and the selection of a particular load program by means of the load interface relay module 801 and/or the digital and analog pins 901 of the control unit 101. Clearly, the latter function (remote program selection), presupposes an invasive and personalized intervention for each load, involving the need to access the printed circuit board and/or the electromechanical buttons physically, all the more so if a direct interface is made between the control unit and the load itself by means of special pins, as shown in fig. 1.

By implementing such functionality, it is possible to achieve smart management of the electric load, so as to regulate its working, optimizing consumption or other performance indexes.

With regard to the recorded parameters, the following table summarizes the possible measurements, which can be taken with the system according to the invention.

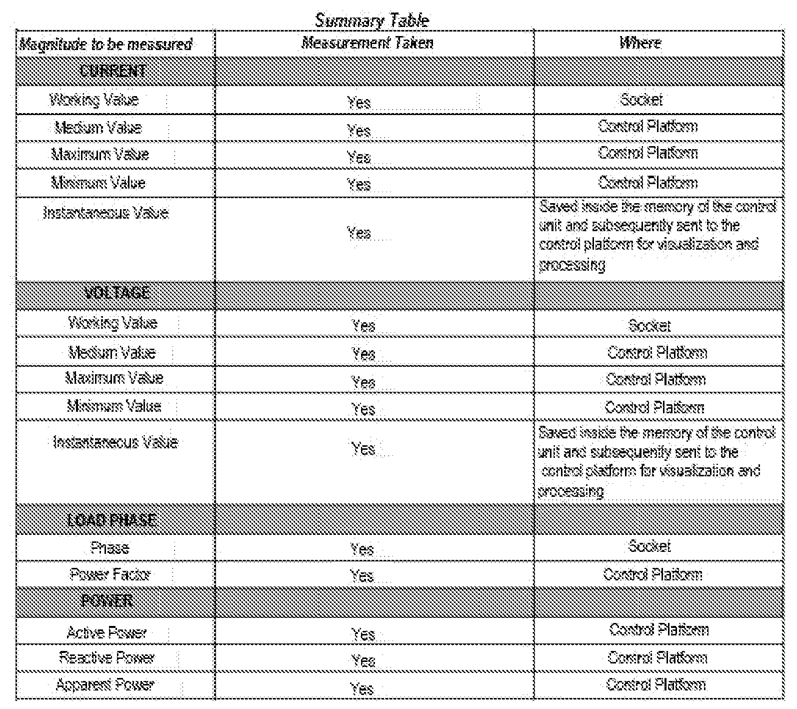

As stated above, it is possible to implement the power factor correction of the load 2 connected to the socket 1 by means of the power factor correction circuit 701 in the smart socket 1, so as to obtain multiple benefits:
- a reduction in dissipated energy. In fact, a corrected load allows users to pay only for the energy effectively used. For example: In a load with inductive cosϕ=0.70, only 70% of the power supplied by the transformer in the cabin is used to produce useful work, while the rest serves to produce the reactive energy requested by the load and dispersed, in part, in the form of heat, by Joule effect;
- an increase in the power available on the supply systems;
- a reduction in voltage drops, with positive consequences on the working of users' equipment;
- a reduction in energy loss in the conductors caused by the reduced intensity of current in circulation at the same power.

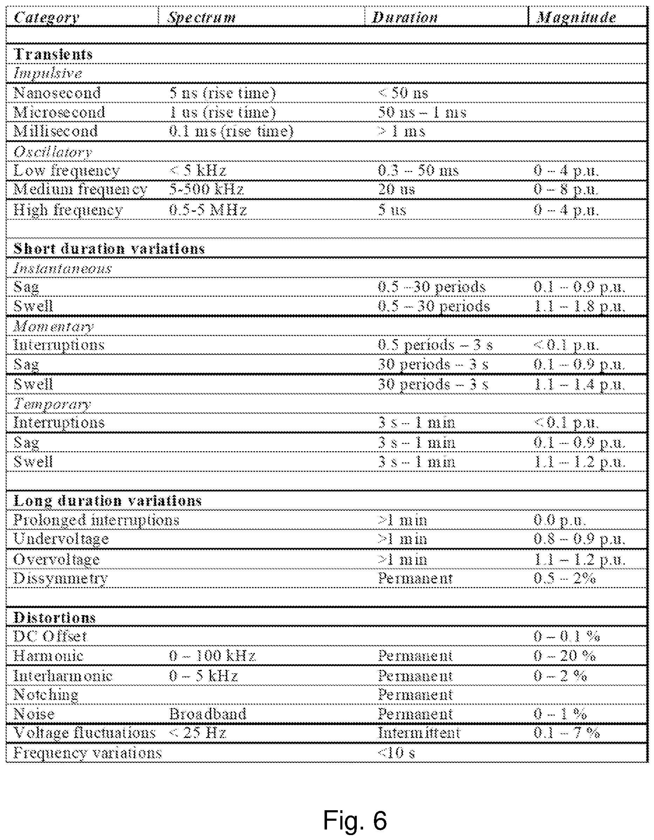

Advantageously, the system is able to perform Power Quality analyses. This term refers to a wide range of electromagnetic phenomena, which characterize the voltage and/or current in a given point of the electric system. By issuing the recommendations Std. 1159-1995, the IEEE proposed a subdivision of the phenomena, the root of disturbances caused in the electrical systems as shown in the table in fig. 6.

## Claims

1. A smart socket (1) for monitoring electric operating parameters of a load, whereby the smart socket is inserted in series between the load and a mains network, comprising:
at least one voltage sensor (501) and a current sensor (401) interfaced with a control unit (101) configured to read the electric mains voltage and drawn current values when the socket is inserted between the load and the mains network;
a communication module (201) interfaced with the control unit (101) configured to send data and receive controls from a remote supervision unit (3);
load control devices (601, 701, 801, 901) configured to operate according to the controls received from the communication module (201) and/or to the controls preset in the control unit (101);
**characterized in that** the load control devices comprise a power factor correction circuit (701) comprising a battery of capacitors in parallel which can be excluded individually by means of break devices arranged in series, such as relays, electronic switches or the like, driven by the control unit (101) to introduce a capacitive reactance into the supply circuit of the load (2) so as to at least partially compensate for the inductive reactance of the load so as to take the power factor to values higher than 0.7, preferably higher than 0.8, typically higher than 0.9.

2. A socket (1) according to claim 1, wherein the load control devices comprise modules (601) which act on the supply circuit of the load (2).

3. A socket (1) according to claim 2, wherein the modules (601) which act on the supply of the load (2) comprise a break device of the current circulation on the load, such as a relay, an electronic switch or the like, driven by the control unit to turn the load on/off.

4. A socket (1) according to one or more of the preceding claims, wherein the load control devices comprise elements (801, 901) which are configured to interface the control unit (101) with the load (2) so as to allow the control unit (101) to set at least part of the respective operating parameters directly on the load (2).

5. A socket (1) according to one or more of the preceding claims, wherein the control unit (101) is configured to receive control signals from the supervision unit (3) for remotely turning on/off, and more in general controlling the operation of the load (2), thus optimizing consumption or other performance indexes according to the monitored operating parameters.

6. A system for monitoring operating parameters of one or more loads present in a mains network, which system comprises one or more supervision units (3) interfaced with one or more smart sockets (1) according to one or more of the preceding claims in order to read data related to the electric mains voltage and current drawn by the load(s) (2) when such smart socket(s) (1) are inserted in series between the electric mains and the load.

7. A system according to claim 6, wherein the supervision unit (3) interfaces with the smart socket(s) (1) by means of a wired or wireless network, particularly by means of Bluetooth, Wifi, Zigbee networks or the like.

8. A system according to claim 6 or 7, wherein the supervision unit (3) is configured to read electric parameters by means of one or more smart sockets (1) and to process such parameters to output a Power Quality analysis of the mains network.

9. A system according to claim 8, wherein the Power Quality analysis comprises processing one or more parameters selected from the list consisting of: effective voltage value, mean voltage value, maximum voltage value, minimum voltage value, effective current value, mean current value, maximum current value, minimum current value, power factor, active power, reactive power, apparent power.

10. A system according to claim 8 or 9, wherein the Power Quality analysis comprises extrapolating one or more categories of electrical disturbances of the electric mains voltage chosen in the group consisting of: impulsive transients, oscillatory transients, instantaneous short duration variations, momentary short duration variations, temporary short duration variations, long duration variations, prolonged interruptions, undervoltages, overvoltages, dissimmetries, distortions due to DC offset, harmonic distortions, interharmonic distortions, notching distorsions, broadband noise distortions, voltage fluctuations distortions, frequency variation distortions.

## Patentansprüche

1. Intelligente Steckdose (1) zur Überwachung elektrischer Betriebsparameter einer Last, wobei die intelligente Steckdose in Reihe zwischen der Last und einem Netz eingefügt ist, umfassend:
mindestens einen Spannungssensor (501) und einen Stromsensor (401), die mit einer Steuereinheit (101) verbunden sind, die so konfiguriert ist, dass sie die Werte der elektrischen Netzspannung und des entnommenen Stroms abliest, wenn die Steckdose zwischen die Last und das Stromnetz geschaltet ist;
ein Kommunikationsmodul (201), das über eine Schnittstelle mit der Steuereinheit (101) verbunden ist und so konfiguriert ist, dass es Daten sendet und Steuerungen von einer entfernten Überwachungseinheit (3) empfängt;
Laststeuerungsvorrichtungen (601, 701, 801, 901), die so konfiguriert sind, dass sie gemäß den vom Kommunikationsmodul (201) empfangenen Steuerungen und/oder gemäß den in der Steuereinheit (101) voreingestellten Steuerungen arbeiten;
**dadurch gekennzeichnet, dass** die Laststeuervorrichtungen eine Leistungsfaktorkorrekturschaltung (701) umfassen, die eine Batterie von parallel geschalteten Kondensatoren umfasst, die einzeln durch in Reihe angeordnete Unterbrechungsvorrichtungen, wie Relais, elektronische Schalter oder dergleichen, ausgeschlossen werden können, die von der Steuereinheit (101) angesteuert werden, um eine kapazitive Reaktanz in den Versorgungskreis der Last (2) einzuführen, um die induktive Reaktanz der Last zumindest teilweise zu kompensieren, um den Leistungsfaktor auf Werte über 0,7, vorzugsweise über 0,8, typischerweise über 0,9 zu bringen.

2. Steckdose (1) nach Anspruch 1, wobei die Laststeuereinrichtungen Module (601) umfassen, die auf den Versorgungskreis der Last (2) einwirken.

3. Steckdose (1) nach Anspruch 2, wobei die Module (601), die auf die Versorgung der Last (2) einwirken, eine Unterbrechungsvorrichtung des Stromkreislaufs an der Last umfassen, wie z. B. ein Relais, einen elektronischen Schalter oder dergleichen, der von der Steuereinheit angesteuert wird, um die Last ein-/auszuschalten.

4. Steckdose (1) nach einem oder mehreren der vorhergehenden Ansprüche, wobei die Laststeuervorrichtungen Elemente (801, 901) umfassen, die so konfiguriert sind, dass sie eine Schnittstelle zwischen der Steuereinheit (101) und der Last (2) bilden, so dass die Steuereinheit (101) zumindest einen Teil der jeweiligen Betriebsparameter direkt an der Last (2) einstellen kann.

5. Steckdose (1) nach einem oder mehreren der vorhergehenden Ansprüche, wobei die Steuereinheit (101) so konfiguriert ist, dass sie Steuersignale von der Überwachungseinheit (3) empfängt, um den Betrieb der Last (2) aus der Ferne ein- und auszuschalten und mehr im Allgemeinen zu steuern und somit den Verbrauch oder andere Leistungsindizes entsprechend den überwachten Betriebsparametern zu optimieren.

6. System zur Überwachung von Betriebsparametern einer oder mehrerer in einem Netz vorhandener Lasten, wobei das System eine oder mehrere Überwachungseinheiten (3) umfasst, die mit einer oder mehreren intelligenten Steckdosen (1) gemäß einem oder mehreren der vorhergehenden Ansprüche verbunden sind, um Daten zu lesen, die sich auf die elektrische Netzspannung und den von der/den Last(en) (2) aufgenommenen Strom beziehen, wenn diese intelligente(n) Steckdose(n) (1) in Reihe zwischen das elektrische Netz und der Last geschaltet sind.

7. System nach Anspruch 6, wobei die Überwachungseinheit (3) mit der/den intelligenten Steckdose(n) (1) über ein drahtgebundenes oder drahtloses Netzwerk verbunden ist, insbesondere über Bluetooth, Wifi, Zigbee-Netzwerke oder dergleichen.

8. System nach Anspruch 6 oder 7, wobei die Überwachungseinheit (3) so konfiguriert ist, dass sie elektrische Parameter mittels einer oder mehrerer intelligenter Steckdosen (1) liest und solche Parameter verarbeitet, um eine Energiequalitätsanalyse des Netzes auszugeben.

9. System nach Anspruch 8, wobei die Energiequalitätsanalyse die Verarbeitung eines oder mehrerer Parameter umfasst, die aus der Liste ausgewählt sind, welche aus Folgendem besteht: effektiver Spannungswert, mittlerer Spannungswert, maximaler Spannungswert, minimaler Spannungswert, effektiver Stromwert, mittlerer Stromwert, maximaler Stromwert, minimaler Stromwert, Leistungsfaktor, Wirkleistung, Blindleistung, Scheinleistung.

10. System nach Anspruch 8 oder 9, wobei die Energiequalitätsanalyse die Extrapolation einer oder mehrerer Kategorien elektrischer Störungen der elektrischen Netzspannung umfasst, die ausgewählt werden aus der Gruppe bestehend aus: Impulstransienten, oszillierende Transienten, momentane Kurzzeitschwankungen, kurzzeitige Kurzzeitschwankungen, vorübergehende Kurzzeitschwankungen, Langzeitschwankungen, längere Unterbrechungen, Unterspannungen, Überspannungen, Abweichungen, Verzerrungen durch Gleichstromversatz, harmonische Verzerrungen, interharmonische Verzerrungen, Kerbverzerrungen, Breitbandrauschverzerrungen, Spannungsschwankungsverzerrungen, Frequenzschwankungsverzerrungen.

## Revendications

1. Prise intelligente (1) pour la surveillance de paramètres électriques de fonctionnement d'une charge, la prise intelligente étant insérée en série entre la charge et un réseau de distribution, comprenant :
au moins un capteur de tension (501) et un capteur de courant (401) interfacés avec une unité de commande (101) configurés pour lire les valeurs de tension de distribution électrique et de courant prélevé lorsque la prise est insérée entre la charge et le réseau de distribution ;
un module de communication (201) interfacé avec l'unité de commande (101) configuré pour envoyer des données et recevoir des commandes à partir d'une unité de supervision distante (3) ;
des dispositifs de commande de charge (601, 701, 801, 901) configurés pour fonctionner selon les commandes reçues à partir du module de communication (201) et/ou selon les commandes prédéfinies dans l'unité de commande (101) ;
**caractérisée en ce que** les dispositifs de commande de charge comprennent un circuit de correction de facteur de puissance (701) comprenant une batterie de condensateurs en parallèle qui peuvent être exclus individuellement au moyen de dispositifs de coupure agencés en série, tels que des relais, des commutateurs électroniques ou similaires, pilotés par l'unité de commande (101) pour introduire une réactance capacitive dans le circuit d'alimentation de la charge (2) de façon à au moins partiellement compenser la réactance inductive de la charge de façon à amener le facteur de puissance à des valeurs supérieures à 0,7, de préférence supérieures à 0,8, typiquement supérieures à 0,9.

2. Prise (1) selon la revendication 1, dans laquelle les dispositifs de commande de charge comprennent des modules (601) qui agissent sur le circuit d'alimentation de la charge (2).

3. Prise (1) selon la revendication 2, dans laquelle les modules (601) qui agissent sur l'alimentation de la charge (2) comprennent un dispositif de coupure de la circulation de courant sur la charge, tel qu'un relais, un commutateur électronique ou similaire, piloté par l'unité de commande pour mettre la charge sous tension/hors tension.

4. Prise (1) selon l'une ou plusieurs des revendications précédentes, dans laquelle les dispositifs de commande de charge comprennent des éléments (801, 901) qui sont configurés pour interfacer l'unité de commande (101) avec la charge (2) de façon à permettre à l'unité de commande (101) de définir au moins une partie des paramètres de fonctionnement respectifs directement sur la charge (2).

5. Prise (1) selon l'une ou plusieurs des revendications précédentes, dans laquelle l'unité de commande (101) est configurée pour recevoir des signaux de commande à partir de l'unité de supervision (3) pour mettre sous tension/hors tension à distance, et plus généralement commander le fonctionnement de la charge (2), en optimisant ainsi la consommation ou d'autres indices de performance selon les paramètres de fonctionnement surveillés.

6. Système pour la surveillance de paramètres de fonctionnement d'une ou de plusieurs charges présentes dans un réseau de distribution, lequel système comprend une ou plusieurs unités de supervision (3) interfacées avec une ou plusieurs prises intelligentes (1) selon l'une ou plusieurs des revendications précédentes afin de lire les données se rapportant à la tension de distribution électrique et au courant prélevé par la ou les charge(s) (2) lorsque de telle(s) prise(s) intelligente(s) (1) sont insérées en série entre la distribution électrique et la charge.

7. Système selon la revendication 6, dans lequel l'unité de supervision (3) s'interface avec la ou les prise(s) intelligente(s) (1) au moyen d'un réseau filaire ou sans fil, en particulier au moyen de réseaux Bluetooth, Wifi, Zigbee ou similaires.

8. Système selon la revendication 6 ou 7, dans lequel l'unité de supervision (3) est configurée pour lire des paramètres électriques au moyen d'une ou de plusieurs prises intelligentes (1) et pour traiter de tels paramètres pour délivrer en sortie une analyse de qualité de puissance du réseau de distribution.

9. Système selon la revendication 8, dans lequel l'analyse de qualité de puissance comprend le traitement d'un ou de plusieurs paramètres sélectionnés parmi la liste constituée de ce qui suit : la valeur de tension efficace, la valeur de tension moyenne, la valeur de tension maximale, la valeur de tension minimale, la valeur de courant efficace, la valeur de courant moyenne, la valeur de courant maximale, la valeur de courant minimale, le facteur de puissance, la puissance active, la puissance réactive, la puissance apparente.

10. Système selon la revendication 8 ou 9, dans lequel l'analyse de qualité de puissance comprend l'extrapolation d'une ou de plusieurs catégories de perturbations électriques de la tension de distribution électrique choisies parmi le groupe constitué de ce qui suit : des transitoires impulsifs, des transitoires oscillatoires, des variations de courte durée instantanées, des variations de courte durée momentanées, des variations de courte durée temporaires, des variations de longue durée, des interruptions prolongées, des sous-tensions, des surtensions, des dissymétries, des distorsions dues à un décalage de courant continu, des distorsions harmoniques, des distorsions interharmoniques, des distorsions en encoche, des distorsions de bruit à large bande, des distorsions de fluctuations de tension, des distorsions de variation de fréquence.
